# EUROPEAN PATENT SPECIFICATION

(11) **EP 0 480 754 B1**
(45) Date of publication and mention of the grant of the patent: **10.04.1996**
(21) Application number: 91309389.4
(22) Date of filing: 11.10.1991
(51) Int. Cl.: H05K 3/34, H05K 3/30

(54) **Mounting device for mounting an electronic device on a substrate by the surface mounting technology**
Montageeinrichtung zum Montieren von einem elektronischen Bauelement über einem Substrat bei der Oberflächemontagetechnologie
Dispositif de montage pour le montage d'un composant électronique sur un substrat au moyen de la technologie de montage en surface

(30) Priority: 11.10.1990 JP 272551/90
(43) Date of publication of application: 15.04.1992
(73) Proprietor: FUJITSU LIMITED, Kawasaki-shi, Kanagawa 211 (JP)
(72) Inventor: Taniuchi, Kenjiro, c/o Fujitsu Limited, Kawasaki-shi, Kanagawa, 211 (JP); Miyazawa, Hideo, c/o Fujitsu Limited, Kawasaki-shi, Kanagawa, 211 (JP); Ishikawa, Kouji, c/o Fujitsu Limited, Kawasaki-shi, Kanagawa, 211 (JP); Watanabe, Kouji, c/o Fujitsu Limited, Kawasaki-shi, Kanagawa, 211 (JP)
(74) Representative: Fane, Christopher Robin King

(56) References cited:
- US-A- 4 216 350
- IBM TECHNICAL DISCLOSURE BULLETIN vol. 21, no. 7, December 1978, pages 2912 - 2913; CIOFFI ET AL.: 'PIN AND SOLDER RING LOADER'

## Description

The present invention relates to the mounting of electronic devices on substrates.

Printed circuit boards are used for supporting electronic devices and for providing interconnections between the devices. The printed circuit board carries thereon a conductor pattern corresponding to the desired wiring or interconnection.

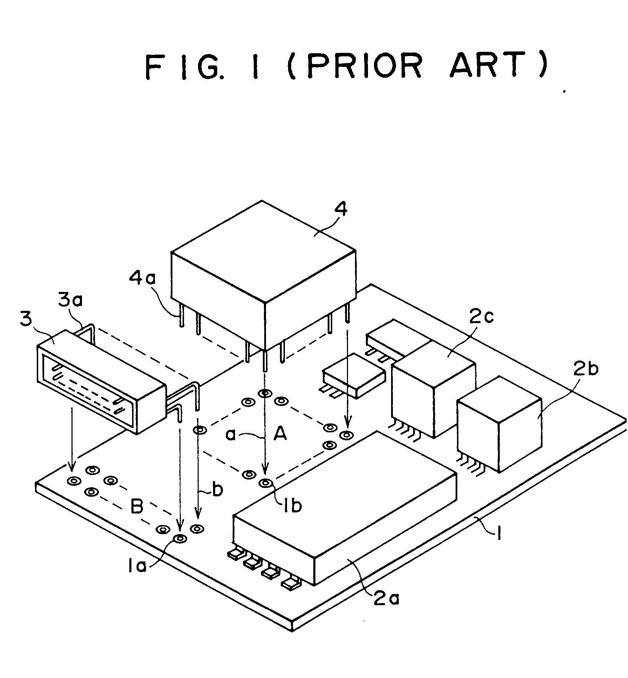

Surface Mounting Technology (SMT) can be used for mounting devices having pins with flattened bottom surfaces, such as devices 2a to 2c shown in the accompanying Figure 1. A solder pattern is provided on a printed circuit board 1 and the devices 2a to 2c are placed thereon such that each pin of the device contacts a corresponding part of the solder pattern. After the devices are thus placed, the whole arrangement is heated to cause the solder located under the pins to melt. This melting process is known as reflowing. On cooling, the pins are fixed firmly on the solder pattern. SMT is easily implemented and helps to reduce the cost of the electronic apparatus.

However, where the pins lack the flattened lower surface for SMT, through-holes are usually provided on the printed circuit board 1 to receive the pins. For example, a connector 3 as shown in Figure 1 has a number of pins 3a adapted to be received by corresponding through-holes 1a in the printed circuit board 1. Further, there are integrated circuits having the PGA structure as shown by an integrated circuit 4. The integrated circuit 4 has a number of interconnection pins 4a arranged in rows and columns on the bottom surface of the body of the integrated circuit. The integrated circuit 4 is mounted on the printed circuit board 1 such that each pin 4a is received by a corresponding through-hole 1b in the printed circuit board 1.

Each through-hole in the printed circuit board 1 carries a metal land and the pins 3a and 4a that are inserted into the through-holes la or 1b are fixed thereto by solder. The soldering is achieved either by dipping the printed circuit board 1 into a molten solder bath (not shown) or by individually soldering each pin by hand. The soldering process used for the surface mounting type device cannot be used, as the surface mounting technology uses a heating apparatus, rather than a molten solder bath, for causing the solder to melt. It should be noted that the temperature used to cause the melting of the solder pattern in the heating apparatus is different from that used in the solder bath. This means that the soldering of the devices 2a to 2c has to be done separately from the soldering of the devices 3 and 4.

US 4,216,350 discloses an electronic apparatus comprising a substrate, having an interconnection pattern connected to a plurality of through-holes extending through the substrate from an upper major surface thereof to a lower major surface thereof, a plate member made of an electrically insulating material, having a lower major surface adjacent to the upper major surface of the substrate and formed with a plurality of through-holes extending through the plate member from an upper major surface thereof to the lower major surface thereof, which through-holes are arranged in register respectively with the through-holes of the substrate and contain respective solder rings, and an electronic device having a plurality of interconnection pins arranged so that the pins pass respectively through the through-holes of the said plate member, via the respective solder rings therein, and are inserted respectively into the through-holes of the substrate, so that the said pins can be connected to the interconnection pattern, and the electronic device and the said plate member can thereby be attached to the said substrate, by reflowing the solder rings.

According to one aspect of the present invention there is provided an electronic apparatus comprising a substrate, having an interconnection pattern connected to a plurality of through-holes extending through the substrate from an upper major surface thereof to a lower major surface thereof, a plate member made of an electrically insulating material, having a lower major surface adjacent to the upper major surface of the substrate and formed with a plurality of through-holes extending through the plate member from an upper major surface thereof to the lower major surface thereof, which through-holes are arranged in register respectively with the through-holes of the substrate and contain respective solder rings, and an electronic device having a plurality of interconnection pins arranged so that the pins pass respectively through the through-holes of the said plate member, via the respective solder rings therein, and are inserted respectively into the through-holes of the substrate, so that the said pins can be connected to the interconnection pattern, and the electronic device and the said plate member can thereby be attached to the said substrate, by reflowing the solder rings, characterised in that each through-hole of the said plate member has an upper portion of a first diameter, which portion extends from the upper surface of the plate member to an intermediate location therein, and a lower portion that is coaxial with the upper portion and extends from the said intermediate location to the lower surface of the plate member, the lower portion of each such through-hole being smaller in diameter than the upper portion thereof so as to provide a shoulder at the said intermediate location, the solder ring in that through-hole being contained in the upper portion of the hole and being larger in external diameter than the said lower portion of the hole.

According to a second aspect of the present invention there is provided a method of mounting an electronic device on a substrate having an interconnection pattern connected to a plurality of through-holes extending through the substrate from an upper major surface thereof to a lower major surface thereof, wherein a plate member, made of an electrically insulating material, is arranged so that a lower major surface thereof is adjacent to the upper major surface of the substrate, the plate member being formed with a plurality of through-holes extending through the plate member from an upper major surface thereof to the lower major surface thereof, which through-holes are arranged in register respectively with the through-holes of the substrate and contain respective solder rings, and wherein the electronic device has a plurality of interconnection pins and is arranged so that the pins pass respectively through the through-holes of the said plate member, via the respective solder rings therein, and are inserted respectively into the through-holes of the substrate, and wherein the said pins are connected to the interconnection pattern, and the electronic device and the said plate member are thereby attached to the said substrate, by reflowing the solder rings; characterised in that each through-hole of the said plate member has an upper portion of a first diameter, which portion extends from the upper surface of the plate member to an intermediate location therein, and a lower portion that is coaxial with the upper portion and extends from the said intermediate location to the lower surface of the plate member, the lower portion of each such through-hole being smaller in diameter than the upper portion thereof so as to provide a shoulder at the said intermediate location, the solder ring in that through-hole being contained, before the reflowing, in the upper portion of the hole and being larger in diameter than the said lower portion of the hole.

An embodiment of the present invention can enable one to mount an electronic device, having pins that are designed to be inserted into corresponding holes of a substrate, by passing the assembled structure through a heating apparatus used for surface mounting technology. Thus soldering can be achieved simultaneously for electronic devices of the surface mounting type and for electronic devices having pins inserted into through-holes of the substrate, so that the efficiency of the mounting process is substantially improved.

Reference will now be made, by way of example, to the accompanying drawings, wherein:
Figure 1 shows a printed circuit board on which various electronic devices are mounted;
Figure 2(A) shows a perspective view of part of an apparatus assembled in accordance with a first embodiment of the present invention;
Figure 2(B) shows an axial sectional view of a detail of the apparatus of Figure 2(B) ;
Figures 3(A) to 3(C) show axial sectional views illustrating respective successive stages of a solder reflowing process applied to the apparatus of Figure 2;
Figure 4 shows a partially cut-away perspective view of components, including a connector, to be employed in an embodiment of the invention;
Figure 5 shows a partially sectioned side view of components to be used in another embodiment of the present invention; and
Figures 6(A) and 6(B) show partially sectioned side views of successive stages in the assembly of an apparatus according to a further embodiment of the present invention.

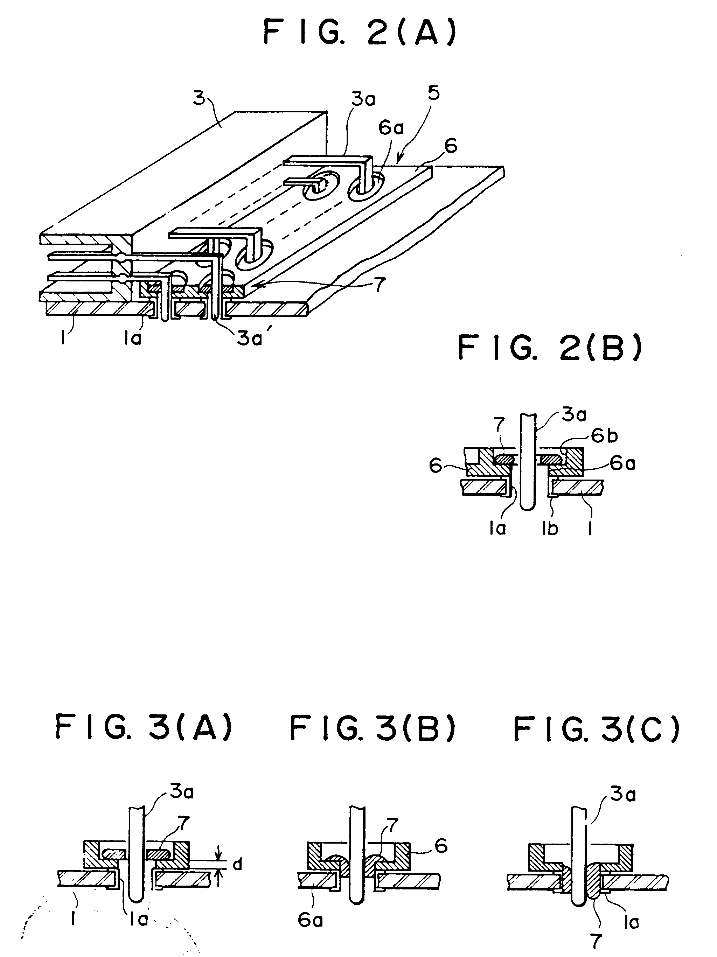

Referring to Figure 2, there is provided a plate 6, of a heat-resistant electrically insulating material such as polyimide, formed with a number of through-holes 6a/6b. Figure 2(A) shows a state in which a connector 3 is provided on the top surface of a printed circuit board 1 together with the plate 6. As shown in Figure 2(A), the through-holes 6a/6b are provided in correspondence to each pin 3a of the connector 3, and the pins 3a are inserted into the corresponding through-holes 6a/6b. The pins 3a extend further and are inserted into through-holes la provided in the printed circuit board 1. It should be noted that each through-hole 6a/6b extends from the bottom surface to the top surface of the plate 6, and the plate 6 is arranged so that the bottom surface of the plate 6 faces the upper major surface of the printed circuit board 1. The through-holes 6a/6b are wide enough to allow the passage of the pins 3a freely.

Further, as shown in Figure 2(B) in detail, each through-hole 6a/6b of the plate 6 has an upper portion in the form of a counter-bore 6b that is coaxial with and larger in diameter than a lower portion 6a of the through-hole, thereby providing a shoulder at an intermediate location within the through-hole. A solder ring 7 is held in the counter-bore 6b, at the shoulder, the ring 7 being larger in external diameter than the lower portion 6a of the through-hole. The appropriate pin 3a of the connector 3 is passed through the central bore of the solder ring 7, and further through the hole 6a/6b until it emerges at the bottom surface of the printed circuit board 1 through the corresponding through-hole la. As shown in this cross section, the through-hole la carries a metal land 1b extending from the top surface to the bottom surface of the printed circuit board 1. As will be described later in detail, the plate 6 is connected to the body of the connector 3 such that the bottom surface of the plate 6 is substantially flush with the bottom surface of the connector 3 and contacts to the land 1b at the top surface of the printed circuit board 1. Needless to say, a metal strip forming an interconnection pattern is provided on one or both of the top and bottom surfaces of the printed circuit board 1, although such a pattern is not explicitly illustrated. Alternatively, it may understood that the metal land 1b forms a part of such an interconnection pattern.

Thus, the plate 6 and the solder ring 7 form a mounting device 5 that is used for mounting an electronic device on a substrate. In the typical example, the solder ring 7 may have an outer diameter of 1.8mm that is smaller than the diameter of the counter-bore 6b and an inner diameter of lmm. The axial height of the solder ring 7 depends on the depth of the counter-bore 6b. Typically, the height may be set to about 1mm in correspondence to the depth of the counter-bore 6b.

Figures 3(A) to 3(C) illustrate a process for soldering the pin 3a by causing a reflow of the solder ring 7.

In the step of Figure 3(A), the pin 3a is passed through the solder ring 7 and further through the through-hole la, as shown also in Figures 2(A) and 2(B).

Next, the structure of Figure 2(A) is passed through a heating apparatus that is used for surface mounting technology, for causing reflow of the solder. The solder ring 7 starts to melt and causes reflow as shown in Figure 3(B), beginning to fill the space between the pin 3a and the wall of the through-hole la. After passing completely through the heating apparatus, the structure is as shown in Figure 3(C), wherein the solder completely fills the space between the pin 3a and the wall of the through-hole la, thereby effectively attaching the device 3 and the plate 6 to the substrate. Typically, a temperature of about 215°C is used in the heating apparatus to cause the reflow of the solder. In order to achieve an effective heating of the solder ring 7, it is preferred to set the thickness d of the plate 6 that corresponds to the lower portion of the hole 6a (see Figure 3(A)) as small as possible. On the other hand, excessively small thickness d may tend to invite damage at this part. The thickness d is preferably set to about 0.3mm.

As will be understood from the above description, the use of the plate 6 and the solder rings 7 enables the mounting of the electronic device having the pins that are inserted into the through-holes of the printed circuit board to be achieved by the heating process used in surface mounting technology. Thus, the mounting of devices such as the devices 3 and 4 can be achieved simultaneously to that of the devices 2a to 2c which are mounted by surface mounting technology.

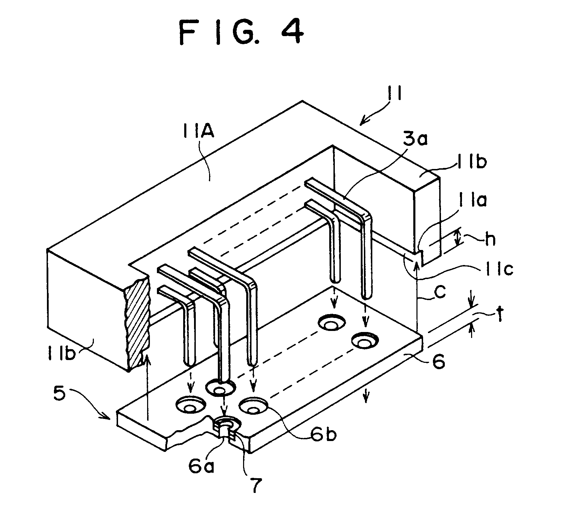

Figure 4 shows the mounting of the device 5 on a connector 11 that corresponds to the connector 3 of Figure 2(A). This process is conducted before the mounting of the connector 3 on the printed circuit board 1.

Referring to Figure 4, the connector 11 has a main part 11A in which a number of pins 3a are provided similarly to the connector 3 of Figure 2(A). Thus, each pin 3a is bent at a right angle and has a generally L-shaped form. At both lateral ends of the part 11A there is provided a guide part llb and the connector generally has a U-shaped form when viewed from the upward direction of the printed circuit board 1.

Along the bottom edge of the parts llA and llb, there is provided a grooved guide region llc with a height h such that the plate 6 of the device 5 is accepted therein when the plate 6 is attached to the connector body as shown by an arrow C. More specifically, the upper boundary of the guide region llc is bounded by a step or shoulder part that prevents further insertion of the plate 6 into the guide region llc. The height h of the guide region is thereby chosen substantially equal to the thickness t of the plate 6.

Before the plate 6 is attached to the connector body 11, a solder ring 7 is, of course, placed into each counter-bore 6b of the through-holes 6a/6b. Such a mounting of the solder rings 7 is easily achieved by loading a number of solder rings 7 on the top surface of the plate 6 and applying shaking. A loading step of this kind is described in IBM Technical Disclosure Bulletin, Vol 21, No. 7, of December 1978, pages 2912 and 2913.

Upon attachment to the connector 11, the plate 6 is held by the pins 3a that establish a frictional engagement with the solder rings 7. Further, the plate 6 may be fixed to the connector 11 by adhesives or glue.

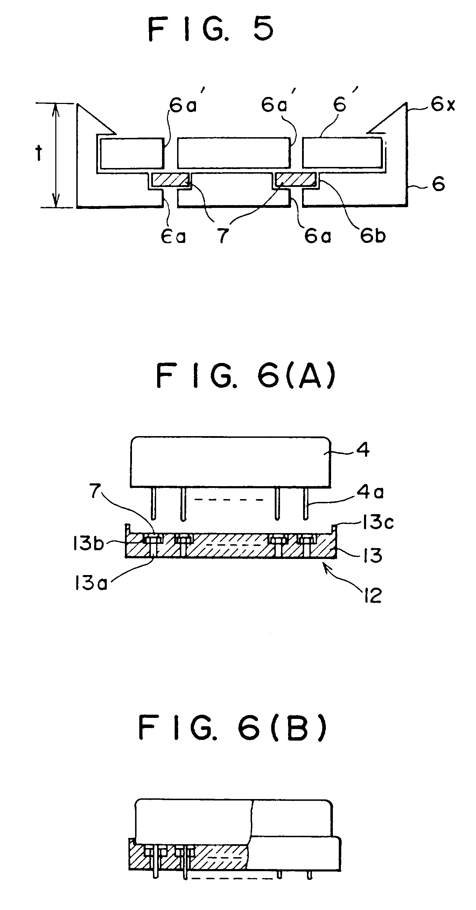

Figure 5 shows a preferred feature for holding the solder rings 7 firmly in the counter-bores 6b when the plate 6 of the mounting device 5 is attached to the connector 11 as shown in Figure 4.

Referring to Figure 5, the plate 6 now has a catch part 6x that is formed along the edges of the plate 6. On the top surface of the plate 6 there is provided a cover plate 6', the top surface of which is held down by the catch part 6x as illustrated. Further, the cover plate 6' is formed with through-holes 6a' in correspondence to the holes 6a of the plate 6 such that the pins 3a of the connector 11 are passed through the holes 6a and 6a' consecutively. Further, the catch part 6x has the overall height t that is set equal to the height h of Figure 4.

In this embodiment, each solder ring 7 is held between the plate 6 and the plate 6' in contact therewith. This prevents the solder ring 7 from coming out of the counter-bore 6b when the device 5 is attached to the connector 11, and the device 5 is held thereto by frictional engagement between the pins 3a and the interior of the solder rings 7.

Figures 6A and 6B show an electronic apparatus comprising a mounting device 12 which includes a plate 13 corresponding to the plate 6. Thus, the plate 13 is provided with a number of through-holes 13a/13b with widened upper portions (counter-bores) 13b respectively corresponding to the counter-bores 6b of the plate 6. Here, the plate 13 is formed to have a shape corresponding to the bottom surface of the integrated circuit 4 of Figure 1, and the through-holes 13a/13b are formed in register with pins 4a of an integrated circuit 4. The integrated circuit 4 has the PGA structure and has the pins 4a extending downward from the bottom surface of the integrated circuit 4. Further, in order to hold the integrated circuit 4 on the top surface of the plate 13, the plate 13 is formed with a support wall 13c extending upwardly around the periphery of the plate, in conformity with the lateral boundaries of the device 4, so that the integrated circuit 4 placed on the plate 13 is supported laterally by the support wall 13c as shown in Figure 6(B).

In this embodiment also, the reflowing process for causing the melting of the solder rings 7 can he achieved by passing the structure of Figure 6(B) through the heating apparatus used also for the surface mounting process, and the mounting of the PGA integrated circuit 4 can thus be achieved simultaneously with the mounting of the surface mounting type devices 2a to 2c of Figure 1.

## Claims

1. An electronic apparatus comprising:
a substrate (1), having an interconnection pattern connected to a plurality of through-holes (la) extending through the substrate from an upper major surface thereof to a lower major surface thereof,
a plate member (6, 13) made of an electrically insulating material, having a lower major surface adjacent to the upper major surface of the substrate and formed with a plurality of through-holes (6a/6b, 13a/13b) extending through the plate member from an upper major surface thereof to the lower major surface thereof, which through-holes (6a/6b, 13a/13b) are arranged in register respectively with the through-holes of the substrate and contain respective solder rings (7), and
an electronic device (3, 4, 11) having a plurality of interconnection pins (3a, 4a) arranged so that the pins pass respectively through the through-holes of the said plate member (6,13), via the respective solder rings therein, and are inserted respectively into the through-holes (la) of the substrate (1), so that the said pins can be connected to the interconnection pattern, and the electronic device and the said plate member can thereby be attached to the said substrate, by reflowing the solder rings;
characterised in that each through-hole (6a/6b, 13a/13b) of the said plate member (6, 13) has an upper portion (6b, 13b) of a first diameter, which portion (6b, 13b) extends from the upper surface of the plate member to an intermediate location therein, and a lower portion (6a, 13a) that is coaxial with the upper portion and extends from the said intermediate location to the lower surface of the plate member, the lower portion (6a, 13a) of each such through-hole being smaller in diameter than the upper portion (6a, 13b) thereof so as to provide a shoulder at the said intermediate location, the solder ring (7) in that through-hole being contained in the upper portion of the hole and being larger in external diameter than the said lower portion of the hole.

2. An apparatus as claimed in claim 1, wherein the internal diameters of the solder rings (7) are such as to establish frictional engagement with the respective pins (3a, 4a) of the electronic device (3, 4, 11).

3. An apparatus as claimed in claim 1, wherein the depth of each said upper portion (6b, 13b) of the through-holes, in the plate member (6, 13), is smaller than the axial height of the solder ring (7) therein.

4. An apparatus as claimed in claim 1 or 2, wherein a cover plate (6') is provided on the upper major surface of the plate member (6), for retaining the solder rings (7) in the said upper portions (6b), the cover plate being provided with a plurality of through-holes (6a'), in register respectively with the through-holes of the substrate (1) and the plate member (6), through which the said pins pass respectively.

5. An apparatus as claimed in claim 4, wherein the plate member (6) is formed, along edge regions of its upper surface, with an upwardly projecting retaining portion (6x) for locating the cover plate.

6. An apparatus as claimed in claim 5, wherein the said retaining portion (6x) is formed as a catch to hold the cover plate (6') down on the upper surface of the plate member (6).

7. An apparatus as claimed in claim 1, wherein the plate member (13) is provided with fixed means (13c) for holding the electronic device (4) on the plate member.

8. An apparatus as claimed in claim 7, wherein the said fixed means (13c) comprises a lateral support wall extending upwardly from peripheral regions of the plate member (13) to engage lateral outer surface regions of the electronic device (4).

9. An apparatus as claimed in any preceding claim, wherein the electronic device comprises an electrical connector (3, 11).

10. An apparatus as claimed in any one of claims 1 to 8, wherein the electronic device comprises an integrated circuit (4).

11. A method of mounting an electronic device (3, 4) on a substrate (1) having an interconnection pattern connected to a plurality of through-holes (la, 13a) extending through the substrate from an upper major surface thereof to a lower major surface thereof, wherein a plate member (6, 13), made of an electrically insulating material, is arranged so that a lower major surface thereof is adjacent to the upper major surface of the substrate, the plate member being formed with a plurality of through-holes (6a/6b, 13a/13b) extending through the plate member from an upper major surface thereof to the lower major surface thereof, which through-holes (6a/6b, 13a/13b) are arranged in register respectively with the through-holes of the substrate and contain respective solder rings (7), and wherein the electronic device (3, 4, 11) has a plurality of interconnection pins (3a, 4a) and is arranged so that the pins pass respectively through the through-holes of the said plate member, via the respective solder rings therein, and are inserted respectively into the through-holes of the substrate, and wherein the said pins are connected to the interconnection pattern, and the electronic device and the said plate member are thereby attached to the said substrate, by reflowing the solder rings;
characterised in that each through-hole (6a/6b, 13a/13b) of the said plate member has an upper portion (6b, 13b) of a first diameter, which portion (6b, 13b) extends from the upper surface of the plate member to an intermediate location therein, and a lower portion (6a) that is coaxial with the upper portion and extends from the said intermediate location to the lower surface of the plate member, the lower portion (6a, 13a) of each such through-hole being smaller in diameter than the upper portion (6b, 13b) thereof so as to provide a shoulder at the said intermediate location, the solder ring (7) in that through-hole being contained, before the reflowing, in the upper portion of the hole and being larger in diameter than the said lower portion of the hole.

12. A method as claimed in claim 11, employing apparatus as claimed in any one of claims 2 to 10.

## Patentansprüche

1. Elektronische Vorrichtung, die umfaßt:
ein Substrat (1), das ein Zwischenverbindungsmuster aufweist, welches mit einer Vielzahl von Durchgangslöchern (1a) verbunden ist, die sich durch das Substrat von einer oberen Hauptoberfläche von diesem zu einer unteren Hauptoberfläche von diesem erstrecken,
ein Plattenelement (6, 13), das aus einem elektrisch isolierenden Material hergestellt ist, an die obere Hauptoberfläche von dem Substrat angrenzend eine untere Hauptoberfläche aufweist und mit einer Vielzahl von Durchgangslöchern (6a/6b, 13a/13b) gebildet ist, die sich durch das Plattenelement von einer oberen Hauptoberfläche von diesem zu dessen unterer Hauptoberfläche erstrecken, welche Durchgangslöcher (6a/6b, 13a/13b) in Ausrichtung jeweils mit den Durchgangslöchern von dem Substrat angeordnet sind und jeweils Lötmittelringe (7) enthalten, und
eine elektronische Einrichtung (3, 4, 11), die eine Vielzahl von Zwischenverbindungstiften (3a, 4a) aufweist, die so angeordnet sind, daß die Stifte jeweils durch die Durchgangslöcher von dem Plattenelement (6, 13) über die entsprechenden Lötmittelringe in diesen hindurchtreten und jeweils-in die Durchgangslöcher (la) von dem Substrat (1) eingefügt sind, so daß die Stifte mit dem Zwischenverbindungsmuster verbunden werden können, und die elektronische Einrichtung und das Plattenelement können dadurch durch Aufschmelzen der Lötmittelringe an dem Substrat angebracht werden;
dadurch gekennzeichnet, daß jedes Durchgangsloch (6a/6b, 13a/13b) von dem Plattenelement (6,13) einen oberen Bereich (6b/13b) mit einem ersten Durchmesser, welcher Bereich (6b, 13b) sich von der oberen Oberfläche von dem Plattenelement zu einer Zwischenstelle in diesem erstreckt, und einen unteren Bereich (6a, 13a) aufweist, der zu dem oberen Bereich koaxial ist und sich von der Zwischenstelle zu der unteren Oberfläche von dem Platteneiement erstreckt, welcher untere Bereich (6a, 13a) von jedem solchen Durchgangsloch im Durchmesser kleiner als dessen oberer Bereich (6b, 13b) ist, um so eine Schulter an dieser Zwischenstelle bereitzustellen, welcher Lötmittelring (7) in diesem Durchgangsloch in dem oberen Bereich von dem Loch enthalten und im äußeren Durchmesser größer als der untere Bereich von dem Loch ist.

2. Vorrichtung gemäß Anspruch 1, bei der die inneren Durchmesser von den Lötmittelringen (7) derart sind, daß ein Reibungseingriff mit den entsprechenden Stiften (3a, 4a) von der elektronischen Einrichtung (3, 4, 11) geschaffen wird.

3. Vorrichtung gemäß Anspruch 1, bei der die Tiefe von jedem oberen Bereich (6b, 13b) von den Durchgangslöchern in dem Plattenelement (6, 13) geringer als die axiale Höhe von dem Lötmittelring (7) darin ist.

4. Vorrichtung gemäß Anspruch 1 oder 2, bei der eine Abdeckplatte (6') auf der oberen Hauptoberfläche von dem Plattenelement (6) zum Zurückhalten der Lötmittelringe (7) in den oberen Bereichen (6b) vorgesehen ist, welche Abdeckplatte mit einer Vielzahl von Durchgangslöchern (6a') in Ausrichtung jeweils mit den Durchgangslöchern von dem Substrat (1) und dem plattenelement (6) versehen ist, durch die die Stifte jeweils hindurchtreten.

5. Vorrichtung gemäß Anspruch 4, bei der das Plattenelement (6) entlang den Kantenbereichen von seiner oberen Oberfläche mit einem aufwärts vorragenden Zurückhaltebereich (6x) zur Lokalisierung der Abdeckplatte gebildet ist.

6. Vorrichtung gemäß Anspruch 5, bei der der Zurückhaltebereich (6x) als ein Anschlag gebildet ist, um die Abdeckplatte (6') auf der oberen Oberfläche auf dem Plattenelement (6) herunterzuhalten.

7. Vorrichtung gemäß Anspruch 1, bei der das Plattenelement (13) mit einem befestigten Mittel (13c) zum Halten der elektronischen Einrichtung (4) auf dem Plattenelement versehen ist.

8. Vorrichtung gemäß Anspruch 7, bei der das befestigte Mittel (13c) eine laterale Tragewand umfaßt, die sich aufwärts von Randbereichen von dem Plattenelement (13) erstreckt, um lateral mit äußeren Oberflächenbereichen von der elektronischen Einrichtung (4) in Eingriff zu stehen.

9. Vorrichtung gemäß einem der vorhergehenden Ansprüche, bei der die elektronische Einrichtung einen elektrischen Verbinder (3, 11) umfaßt.

10. Vorrichtung gemäß einem der Ansprüche 1 bis 8, bei der die elektronische Einrichtung eine integrierte Schaltung (4) umfaßt.

11. Verfahren zur Anbringung einer elektronischer Einrichtung (3, 4) auf einem Substrat (1), das ein Zwischenverbindungsmuster aufweist, das mit einer Vielzahl von Durchgangslöchern (la, 13a) verbunden ist, die sich durch das Substrat von einer oberen Hauptoberfläche von diesem zu einer unteren Hauptoberfläche von diesem erstrecken, wobei ein Plattenelement (6, 13), das aus einem elektrisch isolierenden Material hergestellt ist, angeordnet ist, so daß eine untere Hauptoberfläche von diesem an die obere Hauptoberfläche von dem Substrat angrenzt, welches Plattenelement mit einer Vielzahl von Durchgangslöchern (6a/6b, 13a/13b) gebildet ist, die sich durch das Plattenelement von einer oberen Hauptoberfläche von diesem zu dessen unterer Hauptoberfläche erstrecken, welche Durchgangslöcher (6a/6b, 13a/13b) in Ausrichtung jeweils mit den Durchgangslöchern von dem Substrat angeordnet sind und jeweilige Lötmittelringe (7) enthalten, und wobei die elektronische Einrichtung (3, 4, 11) eine Vielzahl von Zwischenverbindungsstiften (3a, 4a) aufweist und angeordnet ist, so daß die Stifte jeweils durch die Durchgangslöcher von dem Plattenelement über die entsprechenden Lötmittelringe in diesen hindurchtreten und jeweils in die Durchgangslöcher von dem Substrat eingefügt sind, und wobei die Stifte mit dem Zwischenverbindungsmuster verbunden werden, und dadurch die elektronische Einrichtung und das Plattenelement durch Aufschmelzen der Lötmittelringe an dem Substrat angebracht werden;
dadurch gekennzeichnet, daß jedes Durchgangsloch (6a/6b, 13a/13b) von dem Plattenelement einen oberen Bereich (6b, 13b) mit einem ersten Durchmesser, welcher Bereich (6b, 13b) sich von der oberen Oberfläche von dem Plattenelement zu einer Zwischenstelle in diesem erstreckt, und einen unteren Bereich (6a) aufweist, der zu dem oberen Bereich koaxial ist und sich von der Zwischenstelle zu der unteren Oberfläche von dem Plattenelement erstreckt, welcher untere Bereich (6a, 13a) von jedem solchen Durchgangsloch im Durchmesser kleiner als dessen oberer Bereich (6b, 13b) ist, um so eine Schulter an der Zwischenstelle bereitzustellen, welcher Lötmittelring (7) in diesem Durchgangsloch vor dem Aufschmelzen in dem oberen Bereich von dem Loch enthalten und im Durchmesser größer als der untere Bereich von dem Loch ist.

12. Verfahren gemäß Anspruch 11, bei dem eine Vorrichtung gemäß einem der Ansprüche 2 bis 10 verwendet wird.

## Revendications

1. Appareil électronique, comprenant : un substrat (1) ayant un dessin d'interconnexions connecté à plusieurs trous débouchants (la) traversant le substrat d'une grande face supérieure à une grande face inférieure de celui-ci,
un organe (6, 13) à plaque formé d'un matériau isolant de l'électricité, ayant une grande face inférieure adjacente à la grande face supérieure du substrat et comprenant plusieurs trous débouchants (6a/6b, 13a/13b) traversant l'organe à plaque de sa grande face supérieure à sa grande face inférieure, ces trous débouchants (6a/6b, 13a/13b) étant placés en face respectivement des trous débouchants du substrat et contenant des bagues respectives (7) de soudure, et
un dispositif électronique (3, 4, 11) ayant plusieurs broches d'interconnexions (3a, 4a) disposées afin que les broches passent respectivement dans les trous débouchants de l'organe à plaque (6, 13) par l'intermédiaire des bagues respectives de soudure placées dans ces trous, et pénètrent respectivement dans les trous débouchants (la) du substrat (1), si bien que les broches peuvent être connectées au dessin d'interconnexions, et le dispositif électronique et l'organe à plaque peuvent ainsi être fixés au substrat, par refusion des bagues de soudure,
caractérisé en ce que chaque trou débouchant (6a/6b, 13a/13b) de l'organe à plaque (6, 13) possède une partie supérieure (6b, 13b) d'un premier diamètre, cette partie (6b, 13b) dépassant de la surface supérieure de l'organe à plaque vers un emplacement intermédiaire de celui-ci, et une partie inférieure (6a, 13a) qui est coaxiale à la partie supérieure et part de l'emplacement intermédiaire vers la surface inférieure de l'organe à plaque, la partie inférieure (6a, 13a) de chaque trou débouchant ayant un diamètre inférieur à celui de la partie supérieure (6a, 13b) correspondant afin qu'un épaulement soit formé à l'emplacement intermédiaire, la bague (7) de soudure du trou débouchant étant contenue dans la partie supérieure du trou et ayant un diamètre externe supérieur à celui de la partie inférieure du trou.

2. Appareil selon la revendication 1, dans lequel les diamètres internes des bagues (7) de soudure sont tels qu'ils établissent un contact par friction avec les broches respectives (3a, 4a) du dispositif électronique (3, 4, 11).

3. Appareil selon la revendication 1, dans lequel la profondeur de chaque partie supérieure (6b, 13b) des trous débouchants, dans l'organe à plaque (6, 13), est inférieure à la hauteur axiale de la bague de soudure (7) placée à l'intérieur.

4. Appareil selon la revendication 1 ou 2, dans lequel une plaque (6') formant couvercle est placée à la grande face supérieure de l'organe à plaque (6) pour la retenue des bagues (7) de soudure dans les parties supérieures (6b), la plaque de couverture ayant plusieurs trous débouchants (6a') alignés respectivement sur les trous débouchants du substrat (1) et de l'organe à plaque (6) et par lesquels passent respectivement les broches.

5. Appareil selon la revendication 4, dans lequel l'organe à plaque (6) comporte, le long des régions de bord de sa face supérieure, une partie de retenue (6x) dépassant vers le haut et destinée à positionner la plaque de couverture.

6. Appareil selon la revendication 5, dans lequel la partie de retenue (6x) est formée par un bec destiné à maintenir la plaque de couverture (6') sur la surface supérieure de l'organe à plaque (6).

7. Appareil selon la revendication 1, dans lequel l'organe à plaque (13) comporte un dispositif fixe (13c) destiné à maintenir le dispositif électronique (4) sur l'organe à plaque.

8. Appareil selon la revendication 7, dans lequel le dispositif fixe (13c) comporte une paroi latérale de support dépassant au-dessus des régions périphériques de l'organe à plaque (13) et destinée à coopérer avec les régions latérales de la surface externe du dispositif électronique (4).

9. Appareil selon l'une quelconque des revendications précédentes, dans lequel le dispositif électronique est un connecteur électrique (3, 11).

10. Appareil selon l'une quelconque des revendications 1 à 8, dans lequel le dispositif électronique est un circuit intégré (4) .

11. Procédé de montage d'un dispositif électronique (3, 4) sur un substrat (1) ayant un dessin d'interconnexions connecté à plusieurs trous débouchants (la, 13a) traversant le substrat d'une grande face supérieure à une grande face inférieure de celui-ci, dans lequel un organe à plaque (6, 13) formé d'un matériau isolant de l'électricité est placé de manière qu'une grande face inférieure de cet organe soit adjacente à la grande face supérieure du substrat, l'organe à plaque ayant plusieurs trous débouchants (6a/6b, 13a/13b) traversant l'organe à plaque de sa grande face supérieure à sa grande face inférieure, les trous débouchants (6a/6b, 13a/13b) étant alignés respectivement sur les trous débouchants du substrat et contenant des bagues respectives (7) de soudure, et dans lequel le dispositif électronique (3, 4, 11) possède plusieurs broches d'interconnexions (3a, 4a) et est disposé de manière que les broches passent respectivement dans les trous débouchants de l'organe à plaque, par l'intermédiaire des bagues respectives de soudure placées dans les trous, et pénètrent respectivement dans les trous débouchants du substrat, et dans lequel les broches sont connectées au dessin d'interconnexions et le dispositif électronique et l'organe à plaque sont ainsi fixés au substrat par refusion des bagues de soudure,
caractérisé en ce que chaque trou débouchant (6a/6b, 13a/13b) de l'organe à plaque possède une partie supérieure (6b, 13b) d'un premier diamètre, cette partie (6b, 13b) partant de la surface supérieure de l'organe à plaque vers un emplacement intermédiaire, et une partie inférieure (6a) qui est coaxiale à la partie supérieure et part de l'emplacement intermédiaire vers la surface inférieure de l'organe à plaque, la partie inférieure (6a, 13a) de chaque trou débouchant ayant un diamètre inférieur à celui de la partie supérieure (6b, 13b) du trou afin qu'un épaulement soit formé à l'emplacement intermédiaire, la bague (7) de soudure placée dans le trou débouchant étant contenue, avant refusion, à la partie supérieure du trou et ayant un diamètre supérieur à celui de la partie inférieure du trou.

12. Procédé selon la revendication 11, mettant en oeuvre un appareil selon l'une quelconque des revendications 2 à 10.
